# EUROPEAN PATENT APPLICATION

(11) **EP 1 816 361 A1**
(43) Date of publication of application: **08.08.2007**
(21) Application number: 05790648.9
(22) Date of filing: 07.10.2005
(51) Int. Cl.: F16C 32/06, F16C 29/02, H01L 21/027

(54) **BEARING DEVICE AND STAGE DEVICE, AND EXPOSURE DEVICE**

(30) Priority: 18.10.2004 JP 2004302699
(71) Applicant: NIKON CORPORATION, Tokyo 100-8331 (JP)
(72) Inventor: ARAI, Dai, NIKON CORPORATION, Tokyo 100-8331 (JP)
(74) Representative: Hooiveld, Arjen Jan Winfried
(86) International application number: PCT/JP2005/018634
(87) International publication number: WO 2006/043434

(57) **Abstract**

A sufficient moving stroke can be secured without connecting a tube, etc. for supply of air. A movable body (3) having a pad part (73) and a fixed body (2) are provided. The movable body (3) is movably supported by the fixed body (2) by supplying the medium to the pad part (73). A supply part (5) which is provided in the fixed body (2) and to which the medium is supplied; a connecting part (75) which connects the supply part (5) with the pad part (73); and an opening and closing unit (6) which opens and closes the connecting part (75) according to the position of the movable body (3) with respect to the fixed body (2), are provided.

## Description

### TECHNICAL FIELD

The present invention relates to a bearing device which movably supports a movable member using a medium, and a stage device and an exposure apparatus in which the movable body is supported by this bearing device.

This application claims priority to Japanese Patent Application No. 2004-302699 filed October 18, 2004, the entire contents of which are incorporated herein by reference.

### BACKGROUND ART

In a lithography process for manufacturing semiconductor devices, liquid crystal display substrates, etc., an exposure apparatus is used, which transfers and exposes a pattern on a reticle as a mask to each shot region, such as a wafer or a glass substrate, on which a photoresist is coated.

In this type of exposure apparatus, many configurations are adopted in which, as a guide mechanism when a movable body such as a reticle stage or a wafer stage moves, movement of the movable body is supported using a bearing device, are adopted.

Conventionally, as a bearing device which allows the movable body to be movably supported by a fixed body using a medium, such as air, an air bearing can be exemplified. This air bearing has a configuration in which a table that is a movable body moves along a guide shaft that is a fixed body extending in a moving direction while achieving a bearing effect by blowing air toward the guide shaft.

However, since the above configuration needs to be connected to a tube, etc. for supply of air to the movable body, durability of the tube or a space for bending or leading the tube around will be required.

Thus, a method of supplying air to the guide shaft as the fixed body is also conceivable. However, in this configuration, in order to prevent air from leaking from a region in which the table does not fit to the guide shaft, air is always blown off to a region where the table and the guide shaft fit to each other in a movable range of the table. Patent Document 1 discloses a configuration in which an air supply hole and an air discharge hole are provided in a base plate as a fixed body, and supply or discharge of air to or from the movable body through the air supply hole and air discharge hole is performed.
[Patent Document 1]
Japanese Unexamined Patent Application, First Publication No. 2001-20951

### DISCLOSURE OF INVENTION

### PROBLEMS TO BE SOLVED BY THE INVENTION

However, the following problems exist in the related art as described above.

Since the movable body needs to move in a state where a region in which the air supply hole is formed always fits to (covers) the fixed body, a large length will be required. As a result, it will become difficult to secure a sufficient moving stroke.

The present invention has been made in consideration of the above points. It is therefore an object of the invention to provide a bearing device capable of securing a sufficient moving stroke without being connected to a tube, etc. for supply of air, and a stage device and an exposure including the bearing device.

### MEANS FOR SOLVING THE PROBLEM

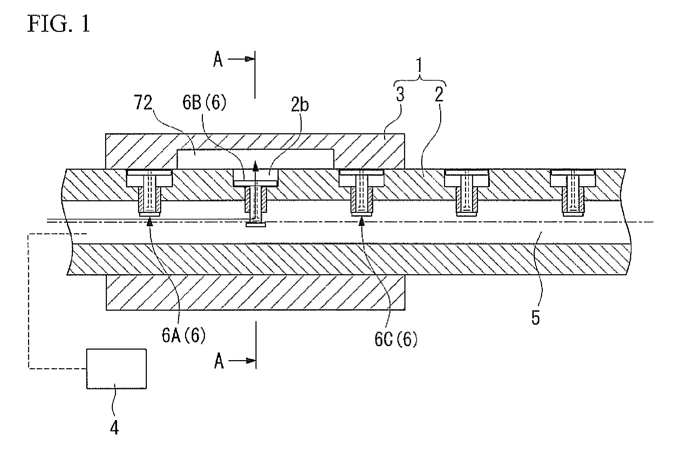

In order to achieve the above object, the present invention adopts the following configurations which are made to correspond to FIGS. 1 to 10 showing embodiments.

The bearing device of the present invention is a bearing device (1) having a movable body (3) having a pad part (73, 79) and a fixed body (2) and supplying a medium to the pad part (73, 79) to movably support the movable body (3) by the fixed body (2). The bearing device includes a supply part (5, 5A, 90) which is provided in the fixed body (2) and to which the medium is supplied, a connecting part (75, 92) which connects the supply part (5, 5A, 90) with the pad part (73, 79), and an opening and closing unit (6, 6A to 6C, 93) which opens and closes the connecting part (75, 92) according to the position of the movable body (3) with respect to the fixed body (2).

Accordingly, in the bearing device of the present invention, when the movable body (3) moves, the opening and closing unit (6, 6A to 6C, 93) in a position corresponding to the position of the movable body (3) can be activated to open the connecting part (75, 92). When the connecting part (75, 92) is opened, a medium is supplied to the pad part (73, 79) through the connecting part (75, 92) from the supply part (5, 5A, 90), thereby supporting movement of the movable body (3) with respect to the fixed body (2). Moreover, when the movable body (3) moves and separates from the opening and closing unit (6, 6A to 6C, 93), the opening and closing unit (6, 6A to 6C, 93) can be activated to close the connecting part (75, 92). Accordingly, since the movable body (3) does not always need to cover a region in which the connecting part (75, 92), such as an air supply hole, is formed, the movable body only needs to have a minimum size. As a result, it is possible to secure a sufficient moving stroke without connecting a tube, etc. for supply of air.

Moreover, the stage device of the present invention is a stage device (12) having a movable member (69A, 69B). Here, the movable member (69A, 69B) is movably supported by the above bearing device (1).

Also, the exposure apparatus of the present invention is an exposure apparatus (10) which exposes a pattern to a substrate (W, W1, W2) placed on a stage device. Here, as the stage device, the above stage device (12) is used.

Accordingly, in the stage device of the present invention, the movable body only needs to have a minimum size without connecting a tube, etc. for supply of air. As a result, the movable member (69A, 69B) can be moved at a sufficient moving stroke.

Moreover, in the exposure apparatus of the present invention, the substrate (W, W1, W2) can be moved at a sufficient moving stroke without connecting a tube, etc. for supply of air concerning exposure of a pattern.

In addition, although the present invention will be described in conjunction with reference numerals of drawings showing embodiments in order to make it clearly understood, it should be understood that the present invention is not limited to the embodiments.

### EFFECTS OF THE INVENTION

As described above, according to the present invention, without being subject to restrictions relating to supply of a medium and without connecting a tube, etc. for supply of air, the length of the movable body can be set freely and a sufficient moving stroke can be secured. Moreover, according to the present invention, without being subject to restrictions relating to supply of a medium, a substrate can be moved at an arbitrary stroke required for exposure processing.

### BRIEF DESCRIPTION OF THE DRAWINGS

FIG. 1 is a view showing an embodiment of the present invention, and is a sectional view showing one embodiment of a bearing device.
FIG. 2 is a sectional view taken along the line A-A in FIG. 1.
FIG. 3 is a partially enlarged view showing principal parts of the bearing device.
FIG. 4A is a view showing the operation of the bearing device.
FIG. 4B is a view showing the operation of the bearing device.
FIG. 4C is a view showing the operation of the bearing device.
FIG. 4D is a view showing the operation of the bearing device.
FIG. 5 is a view showing a second embodiment of the bearing device.
FIG. 6 is a view showing a third embodiment of the bearing device.
FIG. 7 is a view showing a fourth embodiment of the bearing device.
FIG. 8 is a view showing a fifth embodiment of the bearing device.
FIG. 9 is a view showing a schematic configuration of an exposure apparatus according to the present invention.
FIG 10 is a perspective view showing a schematic configuration of a stage device according to the present invention.
FIG. 11 is a flow chart showing an example of manufacturing steps of a semiconductor device.

### DESCRIPTION OF THE REFERENCE SYMBOLS

W, W1, W2 : WAFER (SUBSTRATE)
1 : BEARING DEVICE
2 : GUIDE SHAFT (FIXED BODY)
3 : TABLE (MOVABLE BODY)
5 : AIR SUPPLY PASSAGE (SUPPLY PART)
5A : VACUUM SUCTION PASSAGE (SUPPLY PART)
6, 6A-6C : PILOT VALVE (OPENING AND CLOSING UNIT)
10: EXPOSURE APPARATUS
12: STAGE DEVICE
68A, 68B : Y GUIDE (FIXED BODY)
69A, 69B : Y GUIDE STAGE (MOVABLE BODY, MOVABLE MEMBER)
70 : INTRODUCING PASSAGE (COMMUNICATING PART)
71 : BLEED HOLE (CONNECTING PASSAGE)
72 : AIR RESERVOIR (MEDIUM RESERVOIR)
73, 79 : AIR PAD (PAD PART)
75 : CONNECTING PASSAGE (CONNECTING PART)
90 : AIR SUPPLY PORT (SUPPLY PART)
92 : AIR SUPPLY PIPE (CONNECTING PART)
93 : ELECTROMAGNETIC VALVE (OPENING AND CLOSING UNIT)

### BEST MODE FOR CARRYING OUT THE INVENTION

Hereinafter, embodiments of a bearing device, a stage device, and an exposure apparatus of the present invention will be described with reference to FIGS. 1 to 11.

Here, the bearing device will be described first.

### <First Embodiment>

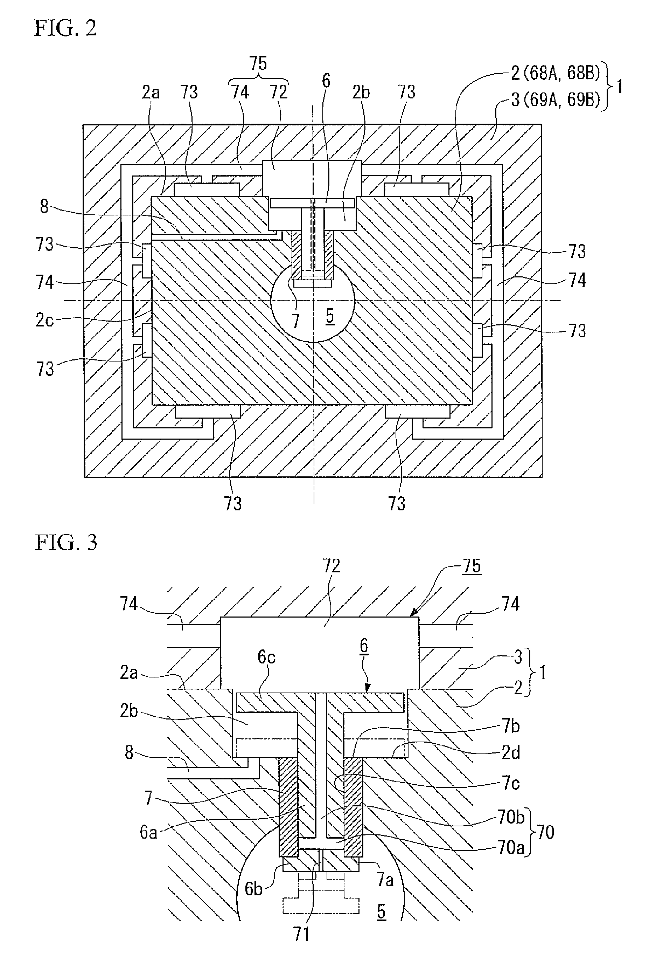

FIG. 1 is a sectional view showing one embodiment of the bearing device, and FIG. 2 is a sectional view taken along a line A-A in FIG. 1.

The bearing device 1 shown in these drawings is mainly composed of a guide shaft (fixed body) 2 extending in the right and left directions in FIG. 1 and having a rectangular cross-section (refer to FIG. 2), and a table (movable body) 3 which is formed in a rectangular cylinder shape in cross-section, and which is fitted to the guide shaft 2 with an infinitesimal gap and is movably supported by the guide shaft.

An air supply passage (supply part) 5 having a round cross-section, to which air as a medium is supplied, is formed at the inner center of the guide shaft 2 along the longitudinal direction. To the air supply passage 5 is supplied air from an air supply source 4 and with, for example, a pressure of about 0.5 MPa, which is greater than the atmospheric pressure. Moreover, a plurality of pilot valves (opening and closing units) 6 and bushes 7 which are arranged at predetermined pitches in the longitudinal direction are provided in a substantially central part of the guide shaft 2 in the width direction thereof.

Each bush 7 is formed in the shape of a cylinder having an axis extending in the up and down directions in the drawing, and as shown in FIG. 3, a lower end face 7a of the bush which is formed flatly is provided so as to project into the air supply passage 5. Moreover, an upper end face 7b of the bush 7 faces a recess 2b provided in a top face 2a of the guide shaft 2 for each bush 7, and is provided substantially flush with a bottom face 2d of the recess 2b. Moreover, an atmosphere communication hole 8 which faces (is open to) each recess 2b and is opened to one side face 2c is formed in the guide shaft 2.

The pilot valve 6 is composed of a shank 6a which is slidably supported by an inner peripheral surface 7c of the bush 7, an engaging part 6b which is located at a bottom end of the shank 6a and is formed so as to be larger in diameter than the shank 6a and approximately equal to the external diameter of the bush 7, and an engaging part 6c which is located at a top end of the shank 6a and is formed so as to be larger in diameter than the engaging part 6b and slightly smaller in diameter than the internal diameter of the recess 2b. The length of the shank 6a (that is, the length between the engaging parts 6b and 6c) is greater than the length of the bush 7, and when the shank 6a slides on the inner peripheral surface 7c of the bush 7, the engaging part 6b engages the lower end face 7a, or the engaging part 6c engages the upper end face 7b (or bottom face 2d of the recess 2b). Moreover, the shank 6a is formed with such a length that the top face of the engaging part 6c does not project from the recess 2b (top face 2a of the guide shaft 2) when the engaging part 6b engages the lower end face 7a of the bush 7.

In addition, in the pilot valve 6, when the shank 6a is lowered downward in FIG. 3, the engaging part 6c engages a higher one of the upper end face 7b of the bush 7 and the bottom face 2d of the recess 2b. However, a description will be made herein assuming that the engaging part 6c engages the bottom face 2d.

An introducing hole 70a penetrating in a direction orthogonal to an axial direction is formed in the vicinity of the bottom end of the shank 6a. The introducing hole 70a is formed in a position where it is not in a blocked state due to the inner peripheral surface 7c of the bush 7 and is opened to the air supply passage 5, when the shank 6a descends and the engaging part 6c engages the bottom face 2d (shown by two-dot chain lines in FIG. 3).

Moreover, an introducing port 70b whose upper end is opened into the recess 2b from the engaging part 6c and whose lower end is opened to the introducing hole 70a is formed axially in the shank 6a. These introducing ports 70a and 70b form an introducing passage 70 for introducing the air supplied to the air supply passage 5 into the recess 2b (or a portion facing the top face of the engaging part 6c).

Furthermore, a bleed hole (connecting passage) 71 whose upper end is opened to the introducing hole 70a and whose lower end is opened to the air supply passage 5 from the engaging part 6b is formed axially in the pilot valve 6. The bleed hole 71 is formed with such a very small aperture that a small amount of air which does not have a substantial influence on the flow rate of the air to be supplied through the air supply passage 5 flows.

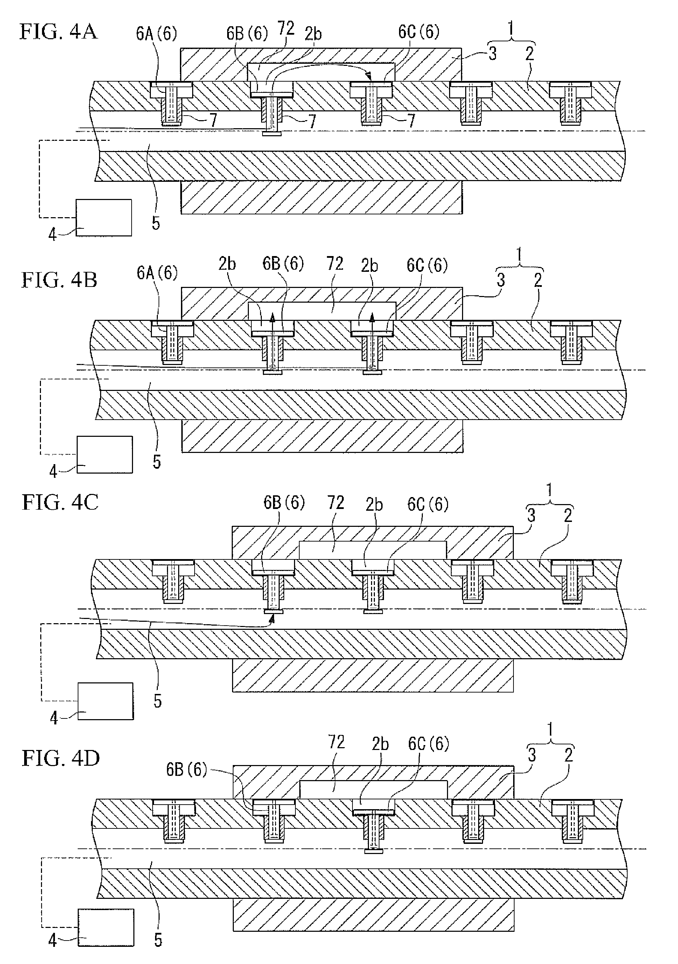

The table 3 has an air reservoir (medium reservoir) 72 in a position where it faces the recess 2b substantially in the center thereof in the width direction at an inner peripheral surface thereof which faces the top face 2a of the guide shaft 2. As shown in FIGS. 2 and 3, with respect to the width direction of the guide shaft 2, the air reservoir 72 is wider than the internal diameter (that is, the external diameter of the engaging part 6c of the pilot valve 6) of the recess 2b. Moreover, as shown in FIG. 4, with respect the longitudinal direction of the guide shaft 2, the air reservoir 72 is formed with such a size that it can cover at least two of the recesses 2b which are arrayed at predetermined pitches. That is, with respect to the longitudinal direction of the guide shaft 2, the length of the air reservoir 72 is greater than a length obtained by adding the internal diameter of the recess 2b to the array pitch of the recesses 2b.

Air pads (pad parts) 73 are provided at the inner peripheral surface of the table 3 which faces the guide shaft 2 in positions where they are spaced apart at predetermined intervals and do not overlap the recesses 2b and atmosphere communication holes 8 which are formed in the guide shaft 2. Each air pad 73 is connected to the air reservoir 72 via an air-supplying internal piping 74.

The introducing passage 70, the air reservoir 72, and the air-supplying internal piping 74 constitute a connecting passage (connecting part) 75 which connects the air supply passage 5 with the air pad 73. Moreover, the introducing passage 70 constitutes a communicating part of the connecting passage 75 which communicates the air supply passage 5 with the air reservoir 72.

Next, the operation of the above bearing device 1 will be described.

As shown in FIG 1, when the air reservoir 72 formed in the table 3 faces a certain pilot valve 6 (a second pilot valve 6 from the left in FIG. 1) (hereinafter, pilot valves are denoted by 6A, 6B, ...), and as shown by two-dot chain lines in FIG. 3, the pilot valve 6B is lowered and thereby the engaging part 6c engages the bottom face 2d, the air supplied to the air supply passage 5 is led to the air reservoir 72 through the introducing passage 70 (introducing holes 70a and 70b), and is then supplied to each air pad 73 through the air-supplying internal piping 74. Then, the table 3 can be smoothly moved in a non-contact manner along the guide shaft 2 by blowing air toward the guide shaft 2 from the air pad 73.

As such, when the pilot valve 6B faces the air reservoir 72, since the external diameter (that is, the area of the top face of the engaging part 6c) of the engaging part 6c is greater than the external diameter (that is, the area of the bottom face of the engaging part 6b) of the engaging part 6b, the force that the engaging part 6c receives from the air in the air reservoir 72 will exceed the force that the engaging part 6b receives from the air in the air supply passage 5. Therefore, the pilot valve 6B will be stably pushed downward, and consequently, air will be supplied to the air reservoir 72.

Subsequently, as shown in FIG. 4A, when the table 3 moves to the right, for example, and the pilot valve 6 (a third pilot valve 6C from the left in the drawing) at the next right position faces the air reservoir 72, a downward force is applied to the engaging part 6c of the pilot valve 6C by the air pressure from the air reservoir 72 in a state where the engaging part 6b receives the air pressure of the air supply passage 5 and then the lower end face 7a of the bush 7 engages the engaging part 6b, At this time, since the recess 2b on the backside (downside) of the engaging part 6c will have atmospheric pressure by the atmosphere communication hole 8, a pressure difference is caused between the top face and bottom face of the engaging part 6c, and a larger air pressure than the atmospheric pressure is applied to the engaging part 6c. Also, as described above, since the engaging part 6c is greater in pressure-receiving area of air pressure than the engaging part 6b, the pilot valve 6C, as shown in FIG. 4B, is lowered (state shown by two-dot chain lines from a state shown by solid lines in FIG. 3), and air is then introduced into the air reservoir 72 through the introducing passage 70 from the air supply passage 5.

Next, as shown in FIG 4C, when movement of the table 3 to the right proceeds, and the pilot valve 6B does not face the air reservoir 72, the air pressure of the air reservoir 72 is not applied to the engaging part 6c of the pilot valve 6B, and consequently the air pressure of the air supply passage 5 is applied to the engaging part 6b. Therefore, if an upward force received from the air supply passage 5 surpasses a downward force by the residual pressure from the air reservoir 72, as shown in FIGS. 4D and 3 (solid line), the pilot valve 6B (in FIG. 3, reference numeral 6) ascends, and thereby the engaging part 6b will engage the bush 7. As a result, the introducing passage 70 is blocked and blow-off of the air from the air supply passage 5 is stopped.

Then, the table 3 will move while the operations of FIGS. 1 and FIGS. 4A to 4D are repeated.

In addition, as described referring to FIG 4A, a downward force is applied to the pilot valve 6C by the air pressure from the air reservoir 72 when the pilot valve 6C faces the air reservoir 72 by movement of the table 3. However, when a certain problem arises and supply of air to the air reservoir 72 has stopped (for example, when the introducing passages 70 are blocked after all the pilot valves 6 have ascended), the air pressure from the air reservoir 72 will not be applied to the pilot valve 6. Moreover, the same is true in the case where driving of the air supply source 4 stops temporarily and needs to be restored.

In such a case, that is, even in a state where the introducing hole 70a is blocked by the bush 7 as shown in FIG. 3, the air supply passage 5 and the air reservoir 72 will be in a connected state by the bleed hole 71 of the pilot valve 6 which faces the air reservoir 72 of the table 3. As a result, the pilot valve 6 can be lowered by the air pressure supplied to the air reservoir 72 through the bleed hole 71 and the introducing passage 70 from the air supply passage 5.

Here, in a region where the table 3 does not fit to the guide shaft 2, air will leak through the bleed hole 71. Thus, as the hole diameter of the bleed hole 71 becomes smaller, loss of an air flow rate becomes less. However, restoration from an initial state (state where the air pressure from the air reservoir 72 is not applied) will take time. Conversely, if the hole diameter of the bleed hole 71 is large, restoration from the initial state is quick, but loss of the air flow rate will increase and a drop in the air pressure in the air supply passage 5 will be caused. Therefore, the hole diameter of the bleed hole 71 is preferably set in consideration of the loss of the air flow rate and the restoration time from the initial state.

As described above, in the present embodiment, the table 3 moves to activate the pilot valve 6 in the position where the air reservoir 72 faces whereby the introducing passage 70 (connecting passage 75) is opened to supply air to the air pad 73. Also, when movement of the table 3 proceeds and the pilot valve 6 does not face the air reservoir 72, the introducing passage 70 (connecting passage 75) is blocked. Therefore, the table 3 is able to move along the guide shaft 2 while supply of air to the air pad 73 is continued, without connecting an air supply tube, etc. regardless of the position of an air supply part (introducing passage 70) arranged in the guide shaft 2 (position where the air supply part fits to the guide shaft 2). Therefore, the length of the table 3 can be set freely, without being limited by the arrangement of the air supply part, and a sufficient moving stroke can be secured.

Moreover, in the present embodiment, since the bleed hole 71 is provided in the pilot valve 6, even when an unexpected situation arises and the air pressure of the air reservoir 72 drops, the pilot valve 6 can be easily restored from its initial state. Therefore, in the present embodiment, complex restoration work can be avoided, and workability can also be improved.

### <Second Embodiment>

Next, a second embodiment of the bearing device will be described.

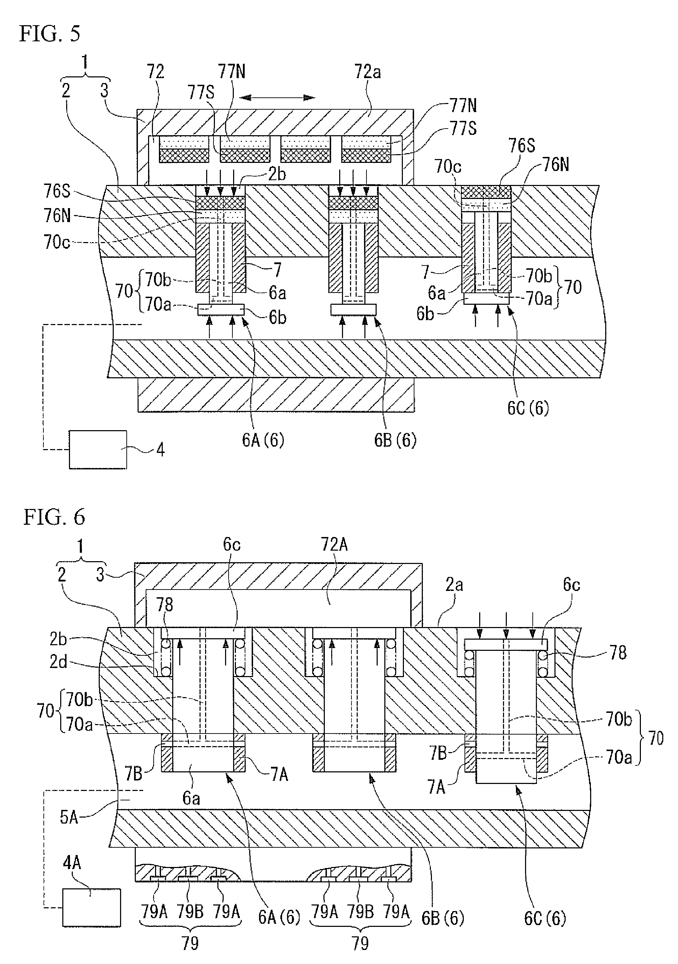

Although the first embodiment has a configuration in which the pilot valve 6 is activated by the air pressure of the air reservoir 72 provided in the table, the present embodiment has a configuration in which a pilot valve is driven by a magnetic force using a magnet. This configuration will be described with reference to FIG. 5. In FIG. 5, the same constituent parts as those of the first embodiment shown in FIGS. 1 to 4D are denoted by the same reference numerals, and the description thereof is omitted.

In the present embodiment, the pilot valve 6 (even in the present embodiment, pilot valves are denoted by 6A, 6B, and 6C from the left in FIG. 6) is composed of the shank 6a, the engaging part 6b, and an N-pole magnet 76N and an S-pole magnet 76S which are sequentially provided at the top end of the shank 6a. An introducing hole 70c which communicates with the introducing hole 70a formed in the shank 6a, and is opened to the recess 2b is provided in each of the magnets 76N and 76S.

Moreover, a plurality of pairs of N-pole magnets 77N and S-pole magnet 77S are arranged in the movement direction (that is, in the longitudinal direction of the guide shaft 2) of the table 3 in a ceiling part 72a of the air reservoir 72 of the table 3. In each pair of magnets, the N-pole magnet 77N is provided in the ceiling part 72a, and the S-pole magnet 77S is provided on the side where it faces the guide shaft 2 (that is, the magnet 76S having the same pole). In this case, a repulsive force generated by the magnets 76S and 77S is set to be greater than a force that the pilot valve 6 receives by the air in the air supply passage 5.

The other configuration is the same as that of the first embodiment.

In the present embodiment, when the magnets 76N and 76S are in the positions where they do not face the magnets 77N and 77S of the table 3 like the pilot valve 6C, the magnetic force of the magnet 77N and 77S is not applied to the magnets 76N and 76S but the air pressure of the air supply passage 5 acts on the engaging part 6b as an upward force. Therefore, the introducing passage 70 is blocked, and blow-off of the air from the air supply passage 5 is stopped accordingly.

On the other hand, when the table 3 moves and the air reservoir 72 and a pilot valve 6 (for example, 6A) face each other, the magnets 76S and 77S having the same pole repulse each other, and the repulsive force causes the pilot valve 6A to descend against the air pressure of the air supply passage 5.

This opens the introducing passage 70, thereby introducing the air in the air supply passage 5 into the air reservoir 72 through the introducing passage 70. Moreover, when the table 3 moves away from the pilot valve 6, similarly to the pilot valve 6C, the repulsive force between the magnets 76S and 77S is eliminated, and an upward force acts on the pilot valve 6A by the air pressure of the air supply passage 5, thereby blocking the introducing passage 70.

As such, in the present embodiment, the pilot valve 6 is activated by the magnetic force of the magnets in addition to having the same operation and providing the same effects as those of the first embodiment. Thus, even when supply of air stops and the air pressure of the air reservoir 72 drops, it is possible to more positively activate the pilot valve 6.

### <Third Embodiment>

Although the first and second embodiments have a configuration in which air is used as a medium, the present embodiment has a configuration in which a vacuum as media is supplied to (is formed in) a vacuum-preloaded air pad (actually, a vacuum state is supplied to the air pad by air being sucked by vacuum suction from the air pad). An example of this configuration will be described with reference to FIG 6.

In the present embodiment, a vacuum suction passage 5A as a vacuum supply part connected to a vacuum suction source 4A is provided in the guide shaft 2. A bush 7A which fits to the shank 6a of the pilot valve 6 is provided in this vacuum suction passage 5A so as to protrude thereinto. The bush 7A is formed with a communicating hole 7B which communicates with the introducing hole 70a formed in the pilot valve 6 and is opened to the vacuum suction passage 5A when the pilot valve 6 ascends upwards and the bush engages an engaging part (not shown), and which is released from the communication with the introducing hole 70a when the pilot valve 6 descends. Moreover, the recess 2b formed in the guide shaft 2 is provided with a preload spring 78, one end of which engages the bottom face 2d, and the other end engages the engaging part 6c of the pilot valve 6 from the bottom to bias the engaging part 6c upward. This preload spring is wound around the shank 6a. The biasing force of the preload spring 78 is set to be smaller than a suction force that the shank 6a receives from the vacuum suction passage 5A when the engaging part 6c is opened under atmospheric pressure.

Moreover, the table 3 has the air reservoir (medium reservoir) 72 in a position where it faces the recess 2b substantially in the center thereof in the width direction at an inner peripheral surface thereof which faces the top face 2a of the guide shaft 2. This vacuum reservoir 72A is connected to a vacuum-preloaded air pad (pad part) 79 through an internal piping. The air pad 79 is provided at the bottom of the table 3, and has an air outlet 79B which blows off air, and an air inlet 79A which sucks out the air on the side of the bottom of the table 3. Also, the air pad serves as a preloaded fluid bearing which forms and maintains a fixed gap between the bottom face of the table 3, and a moving surface by a balance between a repulsive force generated by blow-off of the gas from the air outlet 79B and a suction force generated by the air inlet 79A. In addition, although not shown, if the air supply passage and pilot valve shown in the first and second embodiments are provided in positions different from the vacuum suction passage 5A of the guide shaft 2 and the pilot valve for vacuum, the air reservoir and air-supplying piping are provided in the table 3, and this air-supplying piping is connected to the air outlet 79B, blow-off of air can be realized without using a tube, etc.

In the above configuration, when the vacuum reservoir 72A and the pilot valve 6 (for example, 6A) face each other, the suction force from the vacuum suction passage 5A which acts on the shank 6a, and the suction force from the vacuum reservoir 72A which acts on the engaging part 6c will be offset. Therefore, as the pilot valve 6A ascends by the biasing force of the preload spring 78, and the introducing hole 70a and the communicating hole 7B of the bush 7A communicate with each other, the vacuum state of the vacuum suction passage 5A is supplied to the vacuum reservoir 72A through the introducing passage 70 (actually, the air in the vacuum reservoir 72A is vacuum-sucked to the vacuum suction passage 5A through the introducing passage 70). Thereby, air suction of the air inlet 79A in the air pad 79 is performed.

On the other hand, when the table 3 moves and the vacuum reservoir 72A and the pilot valve 6 (for example, 6C) do not face each other, atmospheric pressure is applied to the engaging part 6c of the pilot valve 6C. Therefore, the pilot valve 6C descends against the biasing force of the preload spring 78. This releases the communication between the introducing hole 70a and the communicating hole 7B, and blocks the introducing passage 70. Accordingly, it is possible to prevent the vacuum suction force of the vacuum suction passage 5A from decreasing.

As such, in the present embodiment, even in a case where a vacuum state is supplied as a medium, it is possible to move the table 3 along the guide shaft 2 while air suction of the air inlet 79A in the air pad 79 is continued, without connecting a tube, etc. to the table 3. Therefore, the length of the table 3 can be set freely, without being limited by the arrangement of a suction part, and a sufficient moving stroke can be secured.

### <Fourth Embodiment>

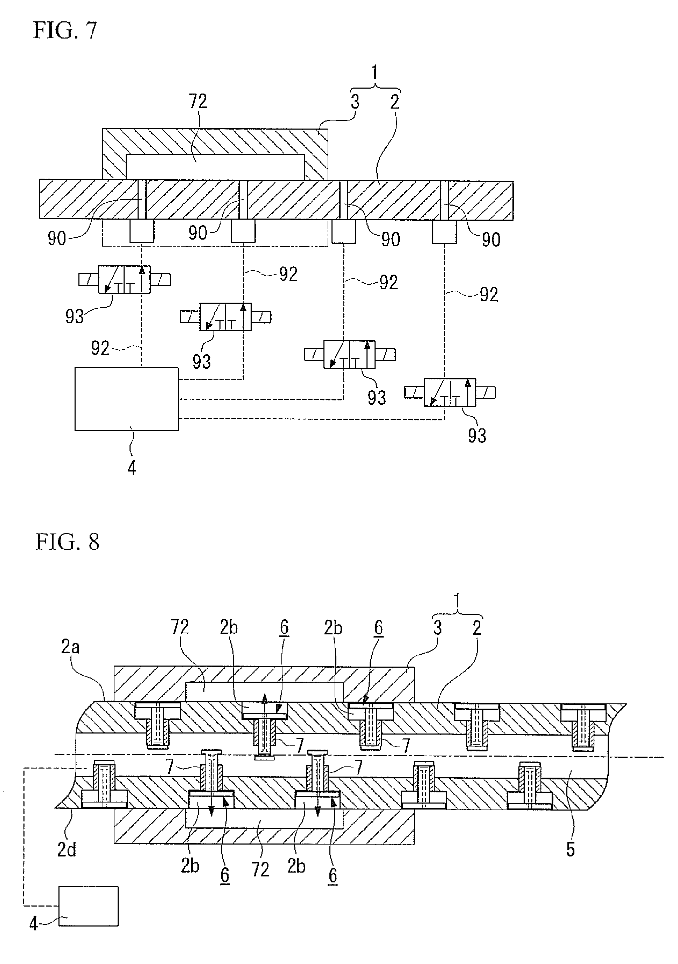

Although the above embodiment has a configuration in which a pilot valve is activated mechanically, and a medium, such as air or a vacuum, is supplied or not supplied to a pad part, the present embodiment has a configuration in which supply of air is controlled electrically using an electromagnetic valve. This configuration will be described with reference to FIG 7. In addition, in FIG. 7, the same constituent parts as those of the first embodiment shown in FIGS. 1 to 4D are denoted by the same reference numerals, and the description thereof is omitted.

As shown in FIG. 7, in the present embodiment, the guide shaft 2 is provided with a plurality of air supply ports (supply part) 90 in the longitudinal direction thereof, and air-supplying connectors 91 are provided in the air supply ports 90, respectively. Each connector 91 is connected to the air supply source 4 through an air supply pipe (connecting part) 92. An electromagnetic valve (opening and closing unit) 93 is interposed in this air supply pipe 92. Each electromagnetic valve 93 is controlled in driving by a control device (not shown), and has a configuration in which supply or shutoff of air to the air supply port 90 through the air-supplying connector 91 is freely switched by switching a solenoid valve.

In the above configuration, the control device switches a solenoid valve of each electromagnetic valve 93 in response to the position of the table 3, to control supply of air to the air reservoir 72.

Specifically, the control device drives an electromagnetic valve 93 connected to an air supply port 90 which faces the air reservoir 72 so that the valve may open a corresponding air supply pipe 92, and conversely, drives an electromagnetic valve 93 connected to an air supply port 90 which does not face the air reservoir 72 so that the valve may block a corresponding air supply pipe 92.

As such, in the present embodiment, it is possible to control the electromagnetic valve 93 to easily regulate supply of air for every air supply port 90 in addition to having the same operation and providing the same effect as the first to third embodiments.

### <Fifth Embodiment>

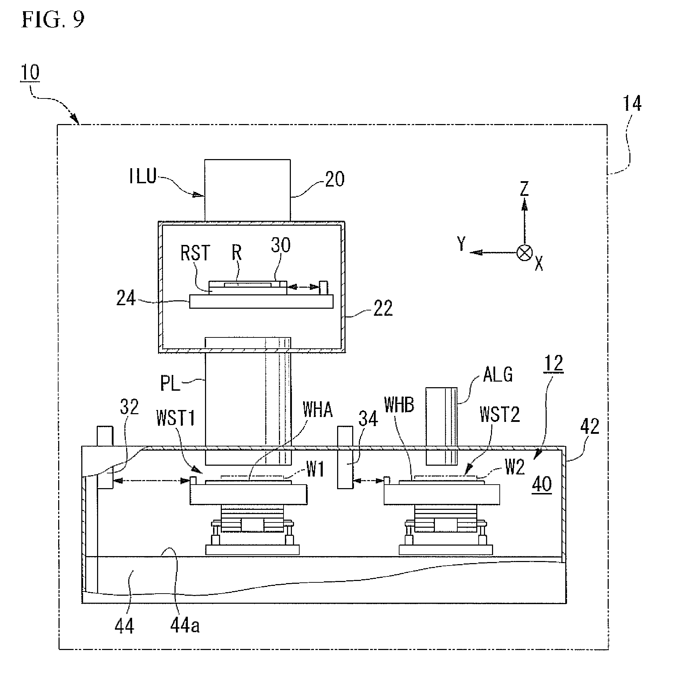

Although the first embodiment has a configuration in which the pilot valves and the air reservoir 72 of the table 3 are provided on one side of the guide shaft 2, the present embodiment has a configuration in which the pilot valves and the air reservoir are provided on both sides of the guide shaft 2. This configuration will be described with reference to FIG. 8.

As shown in FIG. 8, in the present embodiment, the pilot valves 6 and the bushes 7 are respectively arranged at the same pitches and in positions deviated by a half-pitch from each other on the upper and lower sides of the air supply passage 5. Also, the table 3 has air reservoirs 72 in positions where it faces the recesses 2b substantially in the center thereof in the width direction at an inner peripheral surface thereof which faces the top face 2a of the guide shaft 2 and at the inner peripheral surface thereof which faces the bottom face 2d of the guide shaft.

In the configuration shown in FIG. 2, upper air pads 73 and lower air pads 73 are different from each other in the path length of the internal piping 74 for introducing air into the air pads 73 from the air reservoirs 72. Therefore, the amount of air which is blown off from each air pad 73 by a pressure loss in air pressure will become nonuniform. However, in the present embodiment, it is possible to provide the air reservoir 72 on each of the upper and lower sides to control the amount of air blown off from the air pad 73 to become nonuniform.

### <Stage Device and Exposure Apparatus>

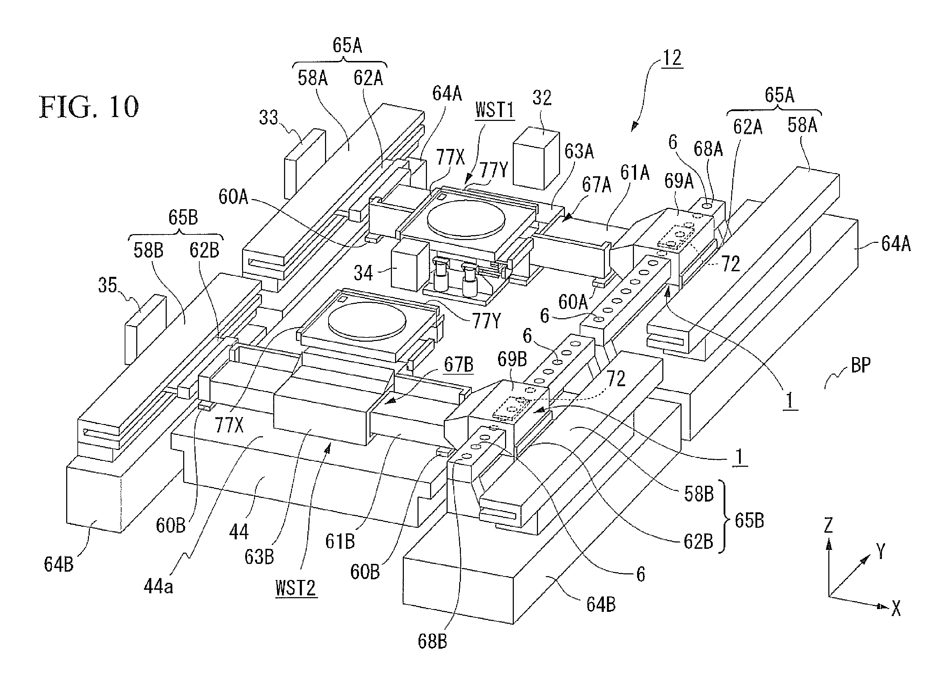

Next, a stage device and an exposure apparatus including the above bearing device 1 will be described with reference to FIGS. 9 and 10. In the present embodiment, the above bearing device 1 is applied to a guide member of a wafer stage in the exposure apparatus. Here, for example, a case where a scanning stepper which transfers a circuit pattern of a semiconductor device formed in a reticle onto a wafer while the reticle and the wafer are synchronously moved is used as the exposure apparatus will be described as an example.

A schematic configuration of the exposure apparatus 10 according to one embodiment is shown in FIG. 9.

This exposure apparatus 10 includes a light source (not shown) and an illumination unit ILU, and is provided with an illumination system which illuminates a reticle R as a mask from the top with illumination light for exposure, a reticle drive system which drives the reticle R substantially in a predetermined scanning direction, here, in a Y-axis direction (right-and-left direction in FIG. 1), a projection optical system PL which is arranged below the reticle R, a stage device 12 as a substrate stage which is arranged below the projection optical system PL and includes wafer stages WST1 and WST2 which independently hold wafers W1 and W2 (appropriately and typically referred to as "W") as substrates and moves in a two-dimensional XY plane, and an alignment optical system ALG which is arranged on the -Y side of the projection optical system PL. The parts except for the light source (not shown) among the above-mentioned parts are installed on the floor surface of a super-clean room, and are housed in an environmentally controlled chamber (hereinafter referred to as "chamber") 14 in which temperature, humidity, etc. are managed with precision.

In addition, the optical axis of the projection optical system PL is disposed in a position on the +Y side of a stage platen 44, and the optical axis of the alignment optical system ALG is disposed in a position on the -Y side of the stage platen 44. Accordingly, the +Y side of the stage platen 44 serves as an exposure area so that exposure processing may be performed on a wafer stage located in this area, while the -Y side of the stage platen 44 serves as an alignment area so that alignment may be performed on a wafer stage located in this area.

The reticle drive system is received in a reticle chamber 22, and a reticle stage (mask stage) RST which is movable in the two-dimensional XY plane on a reticle base board 24 while holding the reticle R. The reticle stage RST is actually composed of a reticle coarse motion stage which is floatingly supported on the reticle base board 24 via a non-contact bearing (not shown), for example, a vacuum preloaded gas hydrostatic bearing device, and which is driven in a predetermined stroke range in the Y-axis direction that is a scanning direction by a linear motor (not shown), and a reticle micro-motion stage which is finely driven in the X-axis direction, in the Y-axis direction, and in the θZ direction (direction of rotation around the Z-axis) with respect to this reticle coarse motion stage by a drive mechanism including a voice coil motor, etc.

The stage device 12 is installed within a chamber 42 which has a wafer chamber 40 formed therein, as shown in FIG. 9. A lens barrel of the projection optical system PL is joined to an upper wall of the chamber 42 without a gap in the vicinity of a bottom end thereof.

The stage device 12 is mainly composed of a stage platen 44 which is housed within the wafer chamber 40, two wafer stages WST1 and WST2 which are floatingly supported above the stage platen 44 via a vacuum preloaded gas hydrostatic bearing device (not shown) that is a non-contact bearing and which are independently and two-dimensionally movable in the Y-axis direction (right-and-left direction in FIG. 9) and in the X-axis direction (direction orthogonal to the sheet plane in FIG. 9), a stage driving system which drives the two wafer stages WST1 and WST2, and a wafer interferometer system which measures the position of the wafer stages WST1 and WST2.

In addition, the wafer chamber 40 is filled with pure helium (helium) gas (He) or dry nitrogen gas (N2) with an air (oxygen) content concentration is about several ppm. Moreover, a wafer loader (not shown) which loads and unloads a wafer is provided in a position on a -Y side half (right half in FIG. 9) on the -X side (near side in FIG. 9) of the chamber 42 which forms the wafer chamber 40.

A schematic perspective view of the stage device 12 which is housed within the chamber 42 is shown in FIG. 10. As shown in FIGS. 10 and 9, the stage device 12 has the stage platen 44, which is horizontally supported at three points or four points via a vibration-proof unit (not shown) on a base plate BP installed at the internal bottom of the chamber 42, a coarse motion stage 63 A which is connected to the wafer stage WST1 and moves along an X guide stage 61A extending in the X direction, a coarse motion stage 63B which is connected to the wafer stage WST2 and moves along an X guide stage 61B extending in the X direction, Y linear motors 65A and 65B which drive the wafer stages WST1 and WST2, respectively, in the Y-axis direction via the coarse motion stages 63A and 63B and the X guide stages 61A and 61B, and X linear motors 67A and 67B which drive the wafer stages WST1 and WST2, respectively, in the X-axis direction via the coarse motion stages 63A and 63B.

A plurality of vacuum-preloaded air bearings 60A and 60B that are non-contact bearings are provided below both ends of the X-guide stages 61A and 61B, respectively. By the balance among the hydrostatic pressure of a pressurizing gas (for example, air, helium, nitrogen gas, etc.) which is blown off from bearing surfaces of the air bearings 60A and 60B, the total self-weight of the guide stages 61A and 61B, and the vacuum suction force, the X guide stages 61 A and 61 B are supported in non-contact with a gap of about several microns above a moving surface 44a that is the top face of the stage platen 44.

The Y linear motors 65A are composed of stators 5 8A which are respectively arranged in the Y-axis direction on both outsides of the stage platen 44 in the X-axis direction, and movers 62A which are respectively provided at both ends of the guide stage 61 A and which are driven in the Y-axis direction along the stators 58A by the electromagnetic interaction with the stators 58A. These stators 58A are supported by supporting blocks 64A which are respectively provided apart in the X-axis direction of the stage platen 44.

Similarly, the Y linear motors 65B are composed of stators 58B which are respectively arranged in the Y-axis direction on both outsides of the stage platen 44 in the Y-axis direction, and movers 62B which are driven in the Y-axis direction along the stators 58B by the electromagnetic interaction with the stators 58B. These stators 58B are supported by supporting blocks 64B, respectively.

Moreover, the Y guides 68A and 68B are provided in the Y-direction in the supporting blocks 64A and 64B located on the +X side, respectively, and Y guide stages (movable member) 69A and 69B which are fitted to and guided by the Y guides 68A and 68B are provided in the movers 62A and 62B located on the +X side. In the present embodiment, the Y guides 68A and 68B are applied to the guide shaft 2 of the first embodiment as fixed bodies, and the Y guide stages 69A and 69B are applied to the table 3 of the first embodiment as movable bodies.

That is, the plurality of pilot valves 6 and air supply passage 5 shown in FIG. 2 are provided in the movement direction of the Y guide stages 69A and 69B in the Y guides 68A and 68B, respectively. Moreover, in the inner peripheral surface of the Y guide stage 69A or 69B which faces the Y guide 68A or 68B, the air reservoir 72 is provided, and the air pad 73 connected to the air reservoir 72 through the internal piping 74 is provided.

The Y-axial position of a wafer stage located in the exposure area is measured by a laser interferometer 32 which is provided outside the stage platen 44 on the +Y side to direct a laser beam to a moving mirror 77Y, and the X-axial position of the wafer stage is measured by a laser interferometer 33 which is provided outside the stage platen 44 on the -X side to direct a laser beam to a moving mirror 77X. Moreover, the Y-axial position of a wafer stage located in the alignment area is measured by a laser interferometer 34 which is disposed on the stage platen 44 provided substantially in the middle (refer to FIG 9) thereof to direct a laser beam to the moving mirror 77Y, and the X-axial position of the wafer stage is measured by a laser interferometer 35 which is provided outside the stage platen 44 on the -X side to direct a laser beam to the moving mirror 77X.

Next, the operation of the stage device 12 in the exposure apparatus 10 according to the present embodiment will be described.

When the wafer stages WST1 and WST2 are moved in the Y-axis direction by an exposure operation or alignment operation, the Y linear motors 65A and 65B are driven at a long stroke along the Y guides 68A and 68B. Moreover, when the wafer stages WST1 and WST2 are moved in the X-axis direction by a step movement, etc., the X linear motors 67A and 67B are driven at a long stroke along the X guides 61A and 61B.

The wafer stages WST1 and WST2 are moved in the Y-axis direction in a state where the Y guide stages 69A and 69B have been guided by the Y guides 68A and 68B. At this time, the pilot valves 6 in positions where they face the air reservoirs 72 of the Y guide stages 69A and 69B, respectively, are opened, and the air supplied from the air supply passages 5 is blown off to the Y guides 68A and 68B through the connecting passages 75 from the air pads 73 whereby the Y guide stages 69A and 69B are supported in a non-contact state with the Y guides 68A and 68B (refer to FIG. 2).

Moreover, since the Y guide stages 69A and 69B move, and the pilot valves 6 in positions where they do not face the air reservoirs 72 block the connecting passages 75, supply of air from the air supply passages 5 is stopped, and unnecessary consumption of air which does not contribute to blow-off from the air pads 73 is suppressed.

Also, in this exposure apparatus 10, while exposure processing is performed on, for example, the wafer W2 on the wafer stage WST2 by means of the projection optical system PL, wafer exchange is performed in the wafer stage WST1, and subsequent to this wafer exchange, an alignment operation and automatic focusing/automatic leveling is performed.

As an exposure sequence, and a wafer exchange/alignment sequence which are performed concurrently on the two wafer stages WST1 and WST2, a wafer stage where the above sequences have been completed first will be in a waiting state, and movement of the wafer stages WST1 and WST2 is controlled when both the operations have been completed.

Also, as for the wafer W2 on the wafer stage WST2 where the exposure sequence has been completed, wafer exchange is performed in a loading position, and as for the wafer W1 on the wafer stage WST1 where the alignment sequence has been completed, the exposure sequence is performed under the projection optical system PL.

As such, it is possible to significantly improve throughput by executing the exposure operation on one wafer stage while the wafer exchange/alignment operation is performed on the other wafer stage and by switching the operations to each other when both the operations have been completed.

In the present embodiment, the Y guides 68A and 68B and the Y guide stages 69A and 69B are composed of the above-mentioned bearing device 1. Thus, it is possible to guide (support) movement of the wafer stages WST1 and WST2 (that is, wafers W1 and W2) in the Y-axis direction with a desired moving stroke without connecting a tube, etc. for supply of air.

In addition, in the present embodiment, the above bearing device 1 can also be applied to, for example, the X guide stages 61A and 61B as fixed bodies and the coarse motion stages 63A and 63B as movable bodies. In this case, it is also possible to adopt the movable bodies in a completely cable/tube-free (that is, friction-free) configuration by adopting a so-called moving magnet type in which coil units are provided in the X guide stage 61A and 6 1 B that are stators of the X linear motors 67A and 67B, and magnet units are provided in the coarse motion stages 63A and 63B that are movers.

Although the preferred embodiments according to the present invention have been described with reference to the accompanying drawings, it should be understood that the present invention is not limited to such embodiments. Various shapes or combinations of respective constituent parts illustrated in the above-described embodiments are merely examples, and various changes may be made depending on design requirements or the like without departing from the spirit or scope of the present invention.

The above embodiments illustrate, for example, air and a vacuum as a medium to be supplied to a pad part. However, in addition to these, lubricating oil can also be supplied as the media in a case where a workpiece and a tool are moved while the lubricating oil is supplied, for example in a machine tool, etc.

Moreover, although the above embodiments illustrate a configuration in which a movable body, such as the table 3, moves along one axis, the present invention is not limited thereto, and can also be applied to a case where the movable body moves along two axes in a plane.

As the substrate W of the above embodiments, not only a semiconductor wafer for a semiconductor device, but also a glass substrate for a liquid crystal display device, a ceramic wafer for a thin-film magnetic head, an original plate (synthetic quartz or silicon wafer) of a mask or reticle, which is used for an exposure apparatus, etc. can be used.

As for the exposure apparatus 10, the present invention can also be applied to a step-and-repeat type projection exposure apparatus (stepper) in which the pattern of a reticle R is exposed in a state where the reticle R and a substrate W are stationary, and the substrate W is sequentially moved stepwise, in addition to a scan-type exposure apparatus in which, while the reticle R and the substrate W are moved synchronously, the pattern of the reticle R is scan-exposed.

Moreover, the present invention can also be applied to a twin-stage-type exposure apparatus as described above. The structure and exposure operation of the twin-stage-type exposure apparatus are disclosed in, for example, Japanese Unexamined Patent Application, First Publication No. H10-163099, Japanese Unexamined Patent Application, First Publication No. H10-214783 (corresponding to U.S. Patent Nos. 6,341,007, 6,400,441, 6,549,269 and 6,590,634), Published Japanese Translation No. 2000-505958 of the PCT International Application (corresponding to U.S. Patent No. 5,696,411), or U.S. Patent No. 6,208,407.

As for the type of the exposure apparatus 10, the present invention is not limited to an exposure apparatus for manufacturing semiconductor devices, which expose a semiconductor device pattern to a wafer. For example, the present invention can also be widely applied to an exposure apparatus which exposes a liquid crystal display pattern to a square glass plate, exposure apparatuses for manufacturing thin-film magnetic heads, charge-coupled devices (CCD), or masks, or the like.

Moreover, as the light source of illumination light for exposure, not only an emission line (g-rays (436 nm)), h-rays (404.7 nm), i-rays (365 nm) generated from an ultra-high pressure mercury lamp, an KrF excimer laser beam (248 nm), an ArF excimer laser beam (193 nm), and an F2 laser beam (157 nm) but also charged particle rays, such as an X ray and an electron ray, can be used. For example, when the electron ray is used, a thermal electron-emission-type lanthanum hexaboride (LaB₆) or tantalum (Ta) light source can be used for an electron gun. Furthermore, when the electron ray is used, a configuration in which the mask M is used may be adopted, and a configuration in which a pattern is directly formed on a wafer without using the mask M may be adopted. Moreover, high-frequency laser beams, such as a YAG laser beam and a semiconductor laser beam, may be used as the light source.

As for the projection optical system PL, it is desirable to use a material, such as quartz or fluorite, which transmits far-ultraviolet rays, as a glass material when far-ultraviolet rays, such as an excimer laser beam, are used, it is desirable to use a reflective refracting system or a refracting system (a reflective reticle is also used as the reticle R) when an F2 laser beam or X ray is used, and it is desirable to use an electron optical system composed of an electron lens and a deflector as an optical system when an electron ray is used. In addition, it is needless to say that an optical path through which an electron ray passes is put into a vacuum state. Moreover, the present invention can also be applied to a proximity exposure apparatus which brings the reticle R and the substrate W into close contact with each other and exposes the pattern of the reticle R, without using the projection optical system PL.

When a linear motor is used for the stage device 12 or the reticle stage RST as in the above embodiments, the present invention is not limited to the air floating type using an air bearing, and a magnetic floating type using a Lorentz force may be used.

A reaction force generated by movement of the wafer stages WST1 and WST2 may be mechanically relieved to a floor (ground) using a frame member, as described in Japanese Unexamined Patent Application, First Publication No. H8-166475. A reaction force generated by movement of the reticle stage RST may be mechanically relieved to a floor (ground) using a frame member, as described in Japanese Unexamined Patent Application, First Publication No. H8-330224.

As described above, the exposure apparatuses 10 of the embodiments of this application are manufactured by assembling various subsystems, including individual components as set forth in the claims of the present application so that predetermined mechanical precision, electrical precision, and optical precision can be maintained. In order to ensure these various precisions, adjustment for achieving optical precision with respect to various optical systems, adjustment for achieving mechanical precision with respect to various mechanical systems, and adjustment for achieving electrical precision with respect to various electrical systems are performed before and after the above assembly. The process of assembly from the various subsystems to the exposure apparatus includes mechanical connection, electrical circuit wiring connection, pneumatic circuit piping connection, etc. among the various subsystems. It is obvious that there are the processes of assembly of each of the subsystems before the process of assembly from these various subsystems to the exposure apparatus. If the process of assembly of the various subsystems to the exposure apparatus has finished, overall adjustment is performed, and consequently the various precisions of the whole exposure apparatus are ensured. It is desirable that manufacture of the exposure apparatus be performed in a clean room in which temperature, cleanness, etc. are managed.

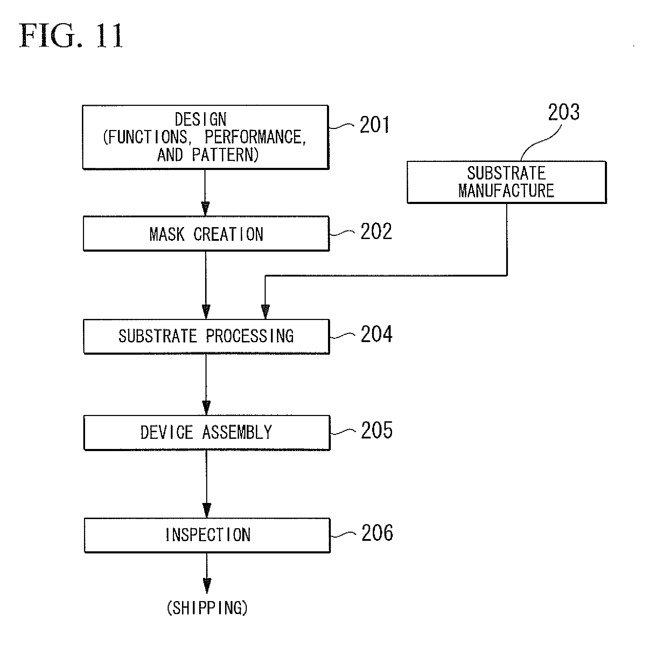

As shown in FIG. 11, semiconductor devices are manufactured through a step 201 of designing the function and performance of a device, a step 202 of fabricating a mask (reticle) on the basis of the designing step, a step 203 of manufacturing a substrate (wafer) that is a device base material, a wafer processing step 204 of exposing a pattern on the mask onto the substrate (wafer) by means of the exposure apparatus 10 of the afore-mentioned embodiments, a device assembling step 205 (including a dicing process, a bonding process, and a packaging process), an inspection step 206, and the like.

## Claims

1. A bearing device having a movable body having a pad part and a fixed body and supplying a medium to the pad part to movably support the movable body by the fixed body, the bearing device comprising:
a supply part which is provided in the fixed body and to which the medium is supplied,
a connecting part which connects the supply part with the pad part, and
an opening and closing unit which opens and closes the connecting part according to the position of the movable body with respect to the fixed body.

2. The bearing device according to Claim 1, wherein
the connecting part has a plurality of communicating parts which are arranged along a moving path of the movable body in the fixed body to communicate with the supply part, and
the opening and closing unit has a valve element which is provided in each of the plurality of communicating parts and which, when the movable body faces a communicating part, opens the communicating part, and when the movable body does not face the communicating part, blocks the communicating part.

3. The bearing device according to Claim 2, wherein
the movable body has a medium reservoir which is provided in a position which faces the communicating part so as to be connected to the pad part, and
the valve element opens the communicating part by the pressure of the medium introduced into the medium reservoir.

4. The bearing device according to Claim 3, wherein the medium reservoirs are provided on both sides of the fixed body.

5. The bearing device according to Claim 3 or 4, wherein the valve element is provided with a connecting passage which makes the supply part and the medium reservoir into a connected state when the movable body faces the communicating part.

6. A stage device having a movable member, wherein the movable member is movably supported by the bearing device according to any one of Claims 1 to 5.

7. An exposure apparatus which exposes a substrate placed on a stage device with a pattern, wherein the stage device according to Claim 6 is used.

8. A bearing device having a movable body having a pad part and a fixed body and supplying a medium to the pad part to movably support the movable body by the fixed body, the bearing device comprising:
a supply part which is provided in the fixed body and to which the medium can be supplied,
a plurality of valve units which can communicate the supply part and the movable body, and
a supply unit which causes at least one valve unit of the plurality of valve units to connect with the supply part and the movable body according to the position of the movable body with respect to the fixed body, to supply the medium to the pad part.

9. The bearing device according to Claim 8, wherein the supply unit supplies the medium to the pad part, using the valve unit of the plurality of valve units which faces the movable body.

10. The bearing device according to Claim 8, wherein
the movable body has a medium reservoir to which the medium from the supply part is to be supplied, and
the valve unit which supplies the medium to the pad part connects with the supply part and the movable body by the pressure of the medium in the medium reservoir.

11. The bearing device according to Claim 10, wherein the pressure of the medium is greater than atmospheric pressure.

12. The bearing device according to Claim 10, wherein the medium reservoir is provided in a position different from the pad part.

13. The bearing device according to Claim 10, wherein the medium reservoirs are provided on both sides of the fixed body.

14. The bearing device according to Claim 8, wherein the valve unit which supplies the medium to the pad part connects with the supply part and the movable body by a magnetic force.

15. The bearing device according to Claim 8, wherein each of the plurality of valve units has an electromagnetic valve.

16. The bearing device according to Claim 8, wherein each of the plurality of valve units has a bleed hole.
